# EUROPEAN PATENT SPECIFICATION

(11) **EP 1 969 419 B1**
(45) Date of publication and mention of the grant of the patent: **30.08.2017**
(21) Application number: 06835592.4
(22) Date of filing: 29.12.2006
(51) Int. Cl.: G02F 1/1333, H01L 51/52

(54) **FLEXIBLE DISPLAY APPARATUS AND METHOD FOR PRODUCING THE SAME**
FLEXIBLE ANZEIGEVORRICHTUNG UND HERSTELLUNGSVERFAHREN DAFÜR
APPAREIL D'AFFICHAGE FLEXIBLE ET PROCEDE DE PRODUCTION DE CELUI-CI

(30) Priority: 30.12.2005 KR 20050134882
(43) Date of publication of application: 17.09.2008
(73) Proprietor: LG Display Co., Ltd., Seoul 150-721 (KR)
(72) Inventor: SON, Se-Hwan, Daejeon Metropolitan City 305-340 (KR); CHOI, Hyeon, Daejeon Metropolitan City 305-761 (KR)
(74) Representative: Viering, Jentschura & Partner mbB Patent- und Rechtsanwälte
(86) International application number: PCT/KR2006/005892
(87) International publication number: WO 2007/078130

(56) References cited:
- JP-A- 2003 033 991
- KR-A- 20000 060 347
- KR-A- 20050 052 304
- KR-A- 20050 060 530
- US-A1- 2002 153 523
- US-A1- 2005 116 637
- US-A1- 2005 153 476

## Description

### [Technical Field]

The present invention relates to a flexible display apparatus that effectively prevents moisture or oxygen from permeating a planarization layer using a protective layer, and a method for producing the same.

This application claims priority from Korean Patent Application No. 10-2005-0134882 filed on December 30, 2005 in the Korean Intellectual Property Office.

### [Background Art]

Generally, a flexible display apparatus is a display apparatus in which a display device is formed on a flexible substrate instead of a thick glass substrate to show visual information even though the apparatus is folded or bent.

Examples of a flexible substrate that is applied to the flexible display apparatus may include a plastic substrate made of an organic material, a substrate having a structure where the organic material and an inorganic material are laminated, and a substrate including metal such as thin stainless steel or aluminum.

Examples of the display device that is applied to the flexible display apparatus include a cholesteric LCD, a PDLC (Polymer Dispersed Liquid Crystal), an electrophoretic device, and an OLED(organic light emitting device).

In the display device, gas permeability of oxygen or moisture to a flexible substrate is important according to the type of display device.

Particularly, since the organic light emitting diode is very vulnerable to oxygen or moisture, there are problems in that performance and a life of the organic light emitting diode are reduced due to permeation of oxygen or moisture.

To avoid the above problems, Korean Patent Registration No. 0300425 discloses a plastic substrate of an organic electroluminescent device that is provided with a plurality of gas barrier layers.

The gas barrier layer may be made of various types of metal oxides as disclosed in Korean Patent Laid-Open Publication No. 2004-0111403, or an organic-inorganic mixture as disclosed in Korean Patent Laid-Open Publication No. 2003-0074783.

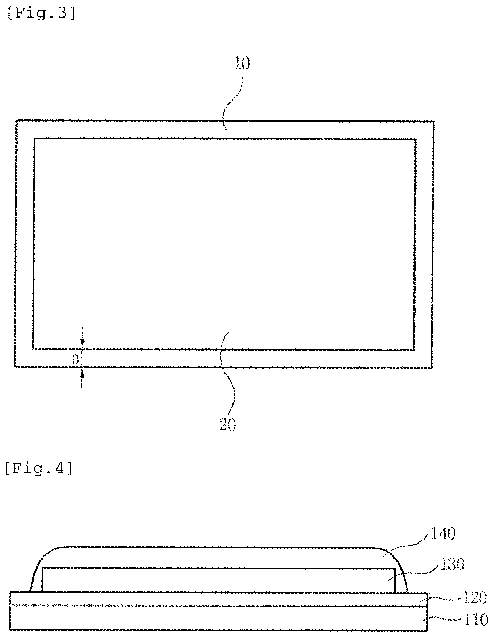

As an example of the flexible display apparatus with the above gas barrier layer, in the case of the flexible display apparatus that is shown in FIG. 4, a gas barrier layer 120 is interposed between a flexible substrate 110 and a display device 130, and a protective layer 140 is provided on the flexible substrate 110 to cover the display device 130.

Meanwhile, the flexible display apparatus may be produced using a stainless steel foil substrate (Z. Xie et a1, Chemical Physics Letters, 381, 691 (2003)) that is developed in order to effectively prevent permeation of oxygen or moisture, or a flexible substrate that is provided with a laminate of aluminum foil and a plastic substrate (Y. Li et al, Applied Physics Letters, 86, 153508 (2005)).

In the case that the above-mentioned flexible substrate is used, in order to assure the desirable planarization of the flexible substrate required in the flexible display apparatus, an organic planarization layer is provided on the flexible substrate.

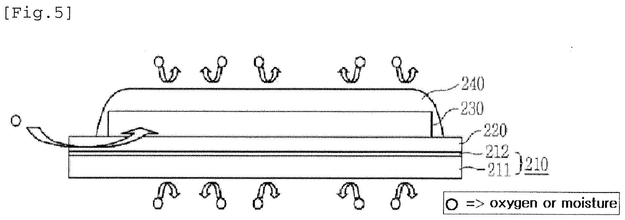

To be more specific, as shown in FIG. 5, a planarization layer 220 is interposed between a flexible substrate 210 including a plastic substrate 211 and a metal thin layer 212 and a display device 230. A protective layer 240 is provided on the flexible substrate 210 to cover the display device 230.

In connection with this, the planarization layer 220 has almost the same area as the flexible substrate 210, and the area that is larger than that of the protective layer 240. Thus, an edge of the planarization layer 220 is exposed.

As shown in FIG. 5, the protective layer 240 prevents moisture or oxygen from permeating from above, and the flexible substrate 210 prevents moisture or oxygen from permeating from below. However, as described above, since the edge of the planarization layer 220 is exposed, there is a problem in that it is impossible to prevent moisture or oxygen from permeating the planarization layer 220 from the side.

### [Disclosure]

### [Technical Problem]

An object of the present invention is to provide a flexible display apparatus that effectively prevents moisture or oxygen from permeating a planarization layer using a protective layer, and a method for producing the same.

### [Technical Solution]

According to the present invention, a flexible display apparatus according to claim 1 is provided.

The flexible substrate may include a resin layer and a metal layer formed on the resin layer.

The resin layer may be made of at least one selected from the group consisting of PET (polyethylene terephthalate), polyester, PEN (polyethylene naphthalate), PEEK (polyetheretherketone), PC (polycarbonate), PES (polyethersulfone), PI (polyimide), PAR (polyarylate), PCO (polycyclic olefin), and polynorbornene.

The metal layer may be made of at least one selected from the group consisting of aluminum and stainless steel.

The metal layer may be formed on the resin layer using a laminating process to provide the flexible substrate.

It is preferable that the planarization layer has a thickness of 10µm and less. It is preferable that an interval between an edge of the planarization layer and an edge of the flexible substrate is 10 cm and less.

The display device may be any one of a cholesteric LCD, a PDLC (Polymer Dispersed Liquid Crystal), an electrophoretic device, and an OLED(organic light emitting device).

It is preferable that the protective layer has an area that is larger than an area of the planarization layer and smaller than an area of the flexible substrate.

The protective layer may form a plastic sheet including a gas barrier material, and be attached to the flexible substrate.

Alternatively, a material selected from the group consisting of a gas barrier material, an organic material, and a mixture thereof may be applied to the flexible substrate to form any one of a single-layer type protective layer and a multilayered protective layer on the flexible substrate.

According to another aspect of the present invention, a method for producing a flexible display apparatus according to claim 11 is provided.

The resin layer may be made of at least one selected from the group consisting of PET (polyethylene terephthalate), polyester, PEN (polyethylene naphthalate), PEEK (polyetheretherketone), PC (polycarbonate), PES (polyethersulfone), PI (polyimide), PAR (polyarylate), PCO (polycyclic olefin), and polynorbornene.

The metal layer may be made of at least one selected from the group consisting of aluminum and stainless steel.

The planarization layer may have a thickness of 10µm and less in step b).

The planarization layer may be formed on the flexible substrate so that an interval between an edge of the planarization layer and an edge of the flexible substrate is 10cm and less in step b).

The display device may be any one of a cholesteric LCD, a PDLC (Polymer Dispersed Liquid Crystal), an electrophoretic device, and an OLED(organic light emitting device) in step c).

It is preferable that the protective layer has an area that is larger than an area of the planarization layer and smaller than an area of the flexible substrate in step d).

The protective layer may form a plastic sheet including a gas barrier material, and be attached to the flexible substrate in step d).

Alternatively, a material selected from the group consisting of a gas barrier material, an organic material, and a mixture thereof may be applied to the flexible substrate to form any one of a single-layer type protective layer and a multilayered protective layer on the flexible substrate.

### [Advantageous Effects]

According to the present invention, since a planarization layer is disposed in a protective layer, it is possible to effectively prevent moisture or oxygen from permeating the planarization layer.

### [Description of Drawings]

The above and other features and advantages of the present invention will become more apparent by describing in detail preferred embodiments thereof with reference to the attached drawings in which:
FIG. 1 is a side view of a flexible display apparatus according to the present invention;
FIG. 2 is a view showing attachment of a plastic substrate and a metal thin layer using a laminating process according to the present invention;
FIG. 3 is a plan view of a flexible substrate and a planarization layer according to the present invention; and
FIGS. 4 and 5 are side views of known flexible display apparatuses.

### -Explanation of the signs that are the main part of the drawings-

- 10 :: flexible substrate
- 11 :: plastic substrate
- 12 :: metal thin layer
- 20 :: planarization layer
- 21 :: inclined side
- 30 :: display device
- 40 :: protective layer
- 51, 52 :: roller

### [Mode for Invention]

Hereinafter, a detailed description will be given of the present invention with reference to the accompanying drawings.

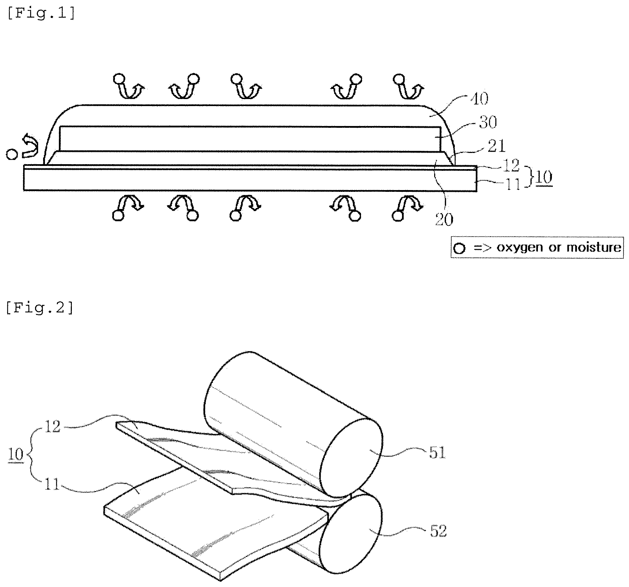

As shown in FIG. 1, a flexible display apparatus according to the present invention is provided with a flexible substrate 10 and a display device 30.

In connection with this, a planarization layer 20 is interposed between the flexible substrate 10 and the display device 30. A protective layer 40 that is provided on the flexible substrate 10 covers both the planarization layer 20 and the display device 30.

The flexible substrate 10 includes a plastic substrate 11 that is a resin layer, and a metal thin layer 12 that is formed on the plastic substrate 11 and formed of a metal layer.

The plastic substrate 11 may be made of one or more which is selected from the group consisting of PET (polyethylene terephthalate), polyester, PEN (polyethylene naphthalate), PEEK (polyetheretherketone), PC (polycarbonate), PES (polyethersulfone), PI (polyimide), PAR (polyarylate), PCO (polycyclic olefin), and polynorbornene.

The metal thin layer 12 may act as a gas barrier layer that prevents gas such as oxygen or moisture from permeating the plastic substrate 11.

The metal thin layer 12 is a thin film that is made of at least one selected from the group consisting of aluminum and stainless steel. In consideration of economic efficiency, it is preferable that an aluminum thin layer be used as the metal thin layer 12. A type of metals is not limited thereto and various types of metals may be applied to the metal thin layer 12.

Since the metal thin layer 12 is a conductor, a short circuit may occur between the electrode of the display device 30 and a driving circuit (not shown) due to the metal thin layer 12. Accordingly, an oxide layer may be formed on the metal thin layer 12 using a plasma treatment process or an electrochemical process in order to prevent the short circuit.

The planarization layer 20 is provided between the flexible substrate 10 and the display device 30 so as to assure the desirable planarization of the flexible substrate 10 required in the flexible display apparatus.

Substantially, the roughness of the flexible substrate 10 is an important factor in the flexible display apparatus. In the case of the organic light emitting diode, it is required that the roughness is 1 nm and less. In the case of the LCD, it is required that the roughness is 5 nm and less. However, in the case of the most metal thin layer, it is difficult to satisfy the above-mentioned conditions due to the characteristic of the production process. Thus, it is necessary to use the planarization layer 20.

As shown in FIG. 3, the planarization layer 20 is formed on the flexible substrate 10 so that an interval (D) between the edge of the planarization layer 20 and the edge of the flexible substrate 10 is 10cm and less. That is, the planarization layer 20 is provided to have the area smaller than that of the flexible substrate 10, and formed on the flexible substrate 10.

The thickness of the planarization layer 20 is not limited as long as flexibility of the flexible display apparatus is not significantly reduced. Preferably, the thickness of the planarization layer is 10µm and less.

It is preferable that the edge of the planarization layer 20 have an inclined side 21 in order to prevent a short circuit of the electrode line (not shown) of the display device 30.

Examples of the display device 30 that is formed on the planarization layer 20 may include a cholesteric LCD (Liquid Crystal Display), a PDLC (Polymer Dispersed Liquid Crystal), an electrophoretic device, and an OLED(organic light emitting device).

The cholesteric LCD has a planar alignment spiral structure, and a characteristic in which light is selectively reflected according to a twisting direction and a pitch of a repeating structure.

The PDLC is one of liquid crystal cells that are applied to the liquid crystal display (LCD), and is characterized in that **transmittance** of light is controlled according to the scattering of light and it is unnecessary to use a polarizing plate.

Examples of the electrophoretic type of device may include a device using capsulated particles which is manufactured by E Ink Corp., a device using charged particles which is manufactured by Bridgestone Corp., a device using spinning of particles which is manufactured by Gyricon, Inc., and a device using movement of particles in a lateral direction.

The OLED(organic light emitting device) has a structure in which electrodes and organic layers are evenly deposited. The organic light emitting diode has a multilayered structure in which four organic layers including a hole injection layer, a hole transport layer, a light emitting layer, and an electron transport layer, and electrodes are evenly deposited. This is not shown in FIG. 1. If voltage is applied between two electrodes, the hole is injected from the anode to the organic layers, and the electron is injected from the cathode to the organic layers. After the injected hole and electron are combined with each other in the light emitting layer to form an exciton, light is emitted in the course of deactivating the exciton, and red, green, and blue colors are displayed according to the type of light emitting layer.

As shown in FIG. 1, the protective layer 40 is provided on the flexible substrate 10 to cover both the display device 30 and the planarization layer 20. Accordingly, both the display device 30 and the planarization layer 20 are provided in a region that is formed by the protective layer 40 and the flexible substrate 10. That is, both the display device 30 and the planarization layer 20 are sealed in the region that is formed by the protective layer 40 and the flexible substrate 10.

In connection with this, the protective layer 40 is provided to have the area that is smaller than that of the flexible substrate 10 and larger than that of the planarization layer 20.

Hereinafter, a description will be given of a method for producing the flexible display apparatus according to the present invention.

The method for producing the flexible display apparatus includes a) preparing the flexible substrate, b) forming the planarization layer having the area that is smaller than that of the flexible substrate on the flexible substrate, c) forming the display device on the planarization layer, and d) forming the protective layer on the flexible substrate to cover both the planarization layer and the display device.

In step a), the metal thin layer 12 may be formed on the plastic substrate 11 using a vacuum thermal evaporation process, an e-beam evaporation process, a sputtering process or the like. As shown in FIG. 2, it is preferable that the plastic substrate 11 and the metal thin layer 12 be attached to each other using the laminating process. The metal thin layer 12 may be simply formed on the plastic substrate 11 using the laminating process without using a costly device.

That is, as shown in FIG. 2, the plastic substrate 11 and the metal thin layer 12 are pressed between a pair of rotating rollers 51 and 52 to easily provide the metal thin layer 12 on the plastic substrate 11. The use of the laminating process is more desirable in comparison with a process using a known vacuum device in the viewpoint of mass production, enlargement in size, and economic efficiency.

In connection with this, in the case that the metal thin layer 12 is attached to the plastic substrate 11 using the above laminating process, it is preferable that the metal thin layer have the thickness of 100µm and less so as to assure desirable flexibility of the flexible substrate 10. In the case that the metal thin layer 12 is very thick, the flexibility of the flexible substrate 10 may be reduced.

In step b), a polyimide-based polymer, a photoacryl-based polymer, an overcoat material, or BCB (benzocyclobutene) may be applied using a coating process such as bar coating and spin coating to provide the planarization layer 20 on the flexible substrate 10. Thereby, the roughness of the flexible substrate 10 may be improved. Additionally, the planarization layer 20 may be formed using a SOG (spin-on-glass) material.

In step c), the display device 30 may be formed on the planarization layer 20 using a vacuum deposition process or a solution coating process such as inkjet printing, screen printing, roll coating, and spin coating.

In step d), a sheet may be produced using a plastic including a gas barrier material, and then attached to the flexible substrate 10 using an adhesive to form the protective layer 40 on the flexible substrate 10.

In connection with this, examples of the plastic material may include PET (polyethylene terephthalate), polyester, PEN (polyethylene naphthalate), PEEK (polyetheretherketone), PC (polycarbonate), PES (polyethersulfone), PI (polyimide), PAR (polyarylate), PCO (polycyclic olefin), and polynorbornene.

Any gas barrier material that is known in the art may be used as the gas barrier material.

Examples of the adhesive may include epoxies and acrylates that are capable of being cured by heat or ultraviolet rays.

Furthermore, in step d), the material that is selected from the group consisting of the gas barrier material, the organic material, and a mixture thereof may be applied on the flexible substrate 10 to form the protective layer 40.

A single-layer type protective layer 40 may be formed on the flexible substrate 10 using any one material that is selected from the group consisting of the gas barrier material, the organic material, and the mixture thereof. Alternatively, a multilayered protective layer 40 having two or more layers may be formed using two or more materials that are selected from the group consisting of the gas barrier material, the organic material, and the mixture thereof.

In connection with this, the protective layer 40 may be formed by means of a vacuum thermal evaporation process, an e-beam evaporation process, a sputtering process, or a sol-gel coating process using an oxide- or nitride-based material that is the gas barrier material.

The oxide-based material may be at least one of silicon oxides, boron oxides, phosphorus oxides, sodium oxides, potassium oxides, lead oxides, titanium oxides, magnesium oxides, and barium oxides. Examples of the nitride-base material may include silicon nitrides.

In the flexible display apparatus that is produced using the method according to the present invention, the protective layer 40 that is provided on the flexible substrate 10 covers both the planarization layer 20 and the display device 30. That is, the planarization layer 20 and the display device 30 are sealed by the protective layer 40. Accordingly, it is possible to effectively prevent moisture or oxygen from permeating the planarization layer 20.

## Claims

1. A flexible display apparatus comprising:
a flexible substrate (11) comprising a resin layer and a metal layer (12) formed on the resin layer;
a planarization layer (21) that has an area smaller than an area of the flexible substrate is formed on the flexible substrate;
a display device (30) that is formed on the planarization layer (21); and
a protective layer (40) that is formed on the flexible substrate (11) to cover both the planarization layer (21) and the display device (30), (30) wherein an edge of the planarization layer (21) has an inclined side.

2. The flexible display apparatus according to claim 1, wherein the protective layer has an area that is larger than an area of the planarization layer and smaller than an area of the flexible substrate.

3. The flexible display apparatus according to claim 1, wherein an interval between an edge of the planarization layer and an edge of the flexible substrate is 10cm and less.

4. The flexible display apparatus according to claim 1, wherein the protective layer forms a plastic sheet including a gas barrier material and is attached to the flexible substrate.

5. The flexible display apparatus according to claim 1,
wherein a material selected from the group consisting of a gas barrier material, an organic material, and a mixture thereof is applied to the flexible substrate to form any one of a single-layer type protective layer and a multilayered protective layer on the flexible substrate.

6. The flexible display apparatus according to claim 1,
wherein the planarization layer has a thickness of 10*µ*m and less.

7. The flexible display apparatus according to claim 1, wherein the display device is any one of a cholesteric LCD, a PDLC (Polymer Dispersed Liquid Crystal), an electrophoretic device, and an OLED(organic light emitting device).

8. The flexible display apparatus according to claim 1, wherein the resin layer is made of at least one selected from the group consisting of PET (polyethylene terephthalate), polyester, PEN (polyethylene naphthalate), PEEK (polyetheretherketone), PC (polycarbonate), PES (polyethersulfone), PI (polyimide), PAR (polyarylate), PCO (polycyclic olefin), and polynorbornene.

9. The flexible display apparatus according to claim 1, wherein the metal layer is made of at least one selected from the group consisting of aluminum and stainless steel.

10. The flexible display apparatus according to claim 1, wherein the metal layer is formed on the resin layer using a laminating process to provide the flexible substrate.

11. A method for producing a flexible display apparatus, comprising the steps of:
a) providing a flexible substrate (11) comprising a resin layer and a metal layer (12) formed on the resin layer;
b) forming a planarization layer (21) that has an area smaller than an area of the flexible substrate on the flexible substrate;
c) forming a display device (30) on the planarization layer (21); and
d) forming a protective layer (40) on the flexible substrate (11) to cover both the planarization layer (21) and the display device (30);
wherein an edge of the planarization layer (21) has an inclined side.

12. The method for producing a flexible display apparatus according to claim 11,
wherein the protective layer has an area that is larger than an area of the planarization layer and smaller than an area of the flexible substrate in step d).

13. The method for producing a flexible display apparatus according to claim 11, wherein the planarization layer is formed on the flexible substrate so that an interval between an edge of the planarization layer and an edge of the flexible substrate is 10cm and less in step b).

14. The method for producing a flexible display apparatus according to claim 11, wherein the protective layer forms a plastic sheet including a gas barrier material and is attached to the flexible substrate in step d).

15. The method for producing a flexible display apparatus according to claim 11, wherein a material selected from the group consisting of a gas barrier material, an organic material, and a mixture thereof is applied to the flexible substrate to form any one of a single-layer type protective layer and a multilayered protective layer on the flexible substrate in step d).

16. The method for producing a flexible display apparatus according to claim 11, wherein the planarization layer has a thickness of 10*µ*m and less in step b).

17. The method for producing a flexible display apparatus according to claim 11, wherein the display device is any one of a cholesteric LCD, a PDLC (Polymer Dispersed Liquid Crystal), an electrophoretic device, and an OLED(organic light emitting device) in step c).

18. The method for producing a flexible display apparatus according to claim 11, wherein a metal layer is formed on a resin layer using a laminating process to provide the flexible substrate in step a).

19. The method for producing a flexible display apparatus according to claim 18, wherein the resin layer is made of at least one selected from the group consisting of PET (polyethylene terephthalate), polyester, PEN (polyethylene naphthalate), PEEK (polyetheretherketone), PC (polycarbonate), PES (polyethersulfone), PI (polyimide), PAR (polyarylate), PCO (polycyclic olefin), and polynorbornene.

20. The method for producing a flexible display apparatus according to claim 18, wherein the metal layer is made of at least one selected from the group consisting of aluminum and stainless steel.

## Patentansprüche

1. Eine flexible Anzeigevorrichtung, aufweisend:
ein flexibles Substrat (11), das eine Harzschicht und eine auf der Harzschicht gebildete Metallschicht (12) aufweist,
eine Planarisierungsschicht (21), welche eine Fläche hat, die kleiner ist als eine Fläche des flexiblen Substrats, und welche auf dem flexiblen Substrat gebildet ist,
eine Anzeigevorrichtung (30), die auf der Planarisierungsschicht (21) gebildet ist, und
eine Schutzschicht (40), die auf dem flexiblen Substrat (11) gebildet ist, um sowohl die Planarisierungsschicht (21) als auch die Anzeigevorrichtung (30) zu bedecken, wobei ein Rand der Planarisierungsschicht (21) eine abgeschrägte Seite hat.

2. Die flexible Anzeigevorrichtung gemäß Anspruch 1, wobei die Schutzschicht eine Fläche hat, die größer ist als eine Fläche der Planarisierungsschicht und kleiner als eine Fläche des flexiblen Substrats.

3. Die flexible Anzeigevorrichtung gemäß Anspruch 1, wobei ein Abstand zwischen einem Rand der Planarisierungsschicht und einem Rand des flexiblen Substrats 10 cm und kleiner ist.

4. Die flexible Anzeigevorrichtung gemäß Anspruch 1, wobei die Schutzschicht eine Kunststofffolie, die ein Gassperre-Material aufweist, bildet und an dem flexiblen Substrat befestigt ist.

5. Die flexible Anzeigevorrichtung gemäß Anspruch 1, wobei ein Material, das ausgewählt ist aus einer Gruppe bestehend aus einem Gassperre-Material, einem organischen Material und einer Mischung davon, auf das flexible Substrat aufgebracht wird, um irgendeine von einer Einzelschicht-Typ-Schutzschicht und einer mehrschichtigen Schutzschicht auf dem flexiblen Substrat zu bilden.

6. Die flexible Anzeigevorrichtung gemäß Anspruch 1,
wobei die Planarisierungsschicht eine Dicke von 10 µm und weniger hat.

7. Die flexible Anzeigevorrichtung gemäß Anspruch 1, wobei die Anzeigevorrichtung irgendeine ist von einem cholesterischen LCD, einem PDLC (Polymer Dispersed Liquid Crystal), einer elektrophoretischen Vorrichtung und einer OLED (organic light emitting device).

8. Die flexible Anzeigevorrichtung gemäß Anspruch 1, wobei die Harzschicht gemacht ist aus mindestens einem ausgewählt aus der Gruppe bestehend aus PET (Polyethylenterephthalat), Polyester, PEN (Polyethylennaphthalat), PEEK (Polyetheretherketon), PC (Polycarbonat), PES (Polyethersulfon), PI (Polyimid), PAR (Polyarylat), PCO (polyzyklisches Olefin) und Polynorbornen.

9. Die flexible Anzeigevorrichtung gemäß Anspruch 1, wobei die Metallschicht gemacht ist aus mindestens einem ausgewählt aus der Gruppe bestehend aus Aluminium und Edelstahl.

10. Die flexible Anzeigevorrichtung gemäß Anspruch 1, wobei die Metallschicht auf der Harzschicht gebildet ist unter Verwendung eines Laminierverfahrens, um das flexible Substrat bereitzustellen.

11. Ein Verfahren zum Herstellen einer flexiblen Anzeigevorrichtung, aufweisend die folgenden Schritte:
a) Bereitstellen eines flexiblen Substrats (11), das eine Harzschicht und eine auf der Harzschicht gebildete Metallschicht (12) aufweist,
b) Bilden einer Planarisierungsschicht (21), die eine Fläche hat, die kleiner ist als eine Fläche des flexiblen Substrats, auf dem flexiblen Substrat,
c) Bilden einer Anzeigevorrichtung (30) auf der Planarisierungsschicht (21), und
d) Bilden einer Schutzschicht (40) auf dem flexiblen Substrat (11), um sowohl die Planarisierungsschicht (21) als auch die Anzeigevorrichtung (31) zu bedecken, wobei ein Rand der Planarisierungsschicht (21) eine abgeschrägte Seite hat.

12. Das Verfahren zum Herstellen einer flexiblen Anzeigevorrichtung gemäß Anspruch 11, wobei die Schutzschicht eine Fläche hat, die größer ist als eine Fläche der Planarisierungsschicht und kleiner als eine Fläche des flexiblen Substrats, in Schritt d).

13. Das Verfahren zum Herstellen einer flexiblen Anzeigevorrichtung gemäß Anspruch 11, wobei die Planarisierungsschicht so auf dem flexiblen Substrat gebildet wird, dass ein Abstand zwischen einem Rand der Planarisierungsschicht und einem Rand des flexiblen Substrats 10 cm und kleiner ist, in Schritt b).

14. Das Verfahren zum Herstellen einer flexiblen Anzeigevorrichtung gemäß Anspruch 11, wobei die Schutzschicht eine Kunststofffolie, die ein Gassperre-Material aufweist, bildet und an dem flexiblen Substrat befestigt wird, in Schritt d).

15. Das Verfahren zum Herstellen einer flexiblen Anzeigevorrichtung gemäß Anspruch 11, wobei ein Material, das ausgewählt ist aus einer Gruppe bestehend aus einem Gassperre-Material, einem organischen Material und einer Mischung davon, auf das flexible Substrat aufgebracht wird, um irgendeine von einer Einzelschicht-Typ-Schutzschicht und einer mehrschichtigen Schutzschicht auf dem flexiblen Substrat zu bilden, in Schritt d).

16. Das Verfahren zum Herstellen einer flexiblen Anzeigevorrichtung gemäß Anspruch 11, wobei die Planarisierungsschicht eine Dicke von 10 µm und weniger hat, in Schritt b).

17. Das Verfahren zum Herstellen einer flexiblen Anzeigevorrichtung gemäß Anspruch 11, wobei die Anzeigevorrichtung irgendeine ist von einem cholesterischen LCD, einem PDLC (Polymer Dispersed Liquid Crystal), einer elektrophoretischen Vorrichtung und einer OLED (organic light emitting device), in Schritt c).

18. Das Verfahren zum Herstellen einer flexiblen Anzeigevorrichtung gemäß Anspruch 11, wobei eine Metallschicht auf einer Harzschicht gebildet wird unter Verwendung eines Laminierverfahrens, um das flexible Substrat bereitzustellen, in Schritt a).

19. Das Verfahren zum Herstellen einer flexiblen Anzeigevorrichtung gemäß Anspruch 18, wobei die Harzschicht gemacht ist aus mindestens einem ausgewählt aus der Gruppe bestehend aus PET (Polyethylenterephthalat), Polyester, PEN (Polyethylennaphthalat), PEEK (Polyetheretherketon), PC (Polycarbonat), PES (Polyethersulfon), PI (Polyimid), PAR (Polyarylat), PCO (polyzyklisches Olefin) und Polynorbornen.

20. Das Verfahren zum Herstellen einer flexiblen Anzeigevorrichtung gemäß Anspruch 18, wobei die Metallschicht gemacht ist aus mindestens einem ausgewählt aus der Gruppe bestehend aus Aluminium und Edelstahl.

## Revendications

1. Appareil d'affichage souple comprenant :
un substrat souple (11) comprenant une couche de résine et une couche de métal (12) formée sur la couche de résine ;
une couche de planarisation (21) qui a une aire plus petite qu'une aire du substrat souple, qui est formée sur le substrat souple ;
un dispositif d'affichage (30) qui est formé sur la couche de planarisation (21) ; et
une couche de protection (40) qui est formée sur le substrat souple (11) de manière à recouvrir à la fois la couche de planarisation (21) et le dispositif d'affichage (30),
dans lequel un bord de la couche de planarisation (21) a un côté incliné.

2. Appareil d'affichage souple selon la revendication 1, dans lequel la couche de protection a une aire qui est plus grande qu'une aire de la couche de planarisation et plus petite qu'une aire du substrat souple.

3. Appareil d'affichage souple selon la revendication 1, dans lequel un intervalle entre un bord de la couche de planarisation et un bord du substrat souple est de 10 cm ou moins.

4. Appareil d'affichage souple selon la revendication 1, dans lequel la couche de protection forme une feuille plastique comprenant un matériau de barrière aux gaz et est attachée au substrat souple.

5. Appareil d'affichage souple selon la revendication 1,
dans lequel un matériau sélectionné dans le groupe consistant en un matériau de barrière aux gaz, un matériau organique, et un mélange de ceux-ci est appliqué au substrat souple pour former l'une quelconque d'une couche de protection du type monocouche et d'une couche de protection multicouche sur le substrat souple.

6. Appareil d'affichage souple selon la revendication 1,
dans lequel la couche de planarisation a une épaisseur de 10 µm ou moins.

7. Appareil d'affichage souple selon la revendication 1, dans lequel le dispositif d'affichage est l'un quelconque d'un LCD cholestérique, d'un PDLC (cristal liquide dispersé dans un polymère), d'un dispositif électrophorétique et d'un OLED (dispositif électroluminescent organique).

8. Appareil d'affichage souple selon la revendication 1, dans lequel la couche de résine est constituée d'au moins un élément sélectionné dans le groupe consistant en le PET (polyéthylène téréphtalate), le polyester, le PEN (polyéthylène naphtalate), le PEEK (polyétheréthercétone), le PC (polycarbonate), le PES (polyéthersulfone), le PI (polyimide), le PAR (polyarylate), la PCO (oléfine polycyclique) et le polynorbornène.

9. Appareil d'affichage souple selon la revendication 1, dans lequel la couche de métal est constituée d'au moins un élément sélectionné dans le groupe consistant en l'aluminium et l'acier inoxydable.

10. Appareil d'affichage souple selon la revendication 1, dans lequel la couche de métal est formée sur la couche de résine en utilisant un processus de lamification pour réaliser le substrat souple.

11. Procédé de fabrication d'un appareil d'affichage souple, comprenant les étapes :
a) de réalisation d'un substrat souple (11) comprenant une couche de résine et une couche de métal (12) formée sur la couche de résine ;
b) de formation d'une couche de planarisation (21) qui a une aire plus petite qu'une aire du substrat souple sur le substrat souple ;
c) de formation d'un dispositif d'affichage (30) sur la couche de planarisation (21) ; et
d) de formation d'une couche de protection (40) sur le substrat souple (11) de manière à recouvrir à la fois la couche de planarisation (21) et le dispositif d'affichage (30) ;
dans lequel un bord de la couche de planarisation (21) a un côté incliné.

12. Procédé de fabrication d'un appareil d'affichage souple selon la revendication 11,
dans lequel la couche de protection a une aire qui est plus grande qu'une aire de la couche de planarisation et plus petite qu'une aire du substrat souple à l'étape d).

13. Procédé de fabrication d'un appareil d'affichage souple selon la revendication 11, dans lequel la couche de planarisation est formée sur le substrat souple de sorte qu'un intervalle entre un bord de la couche de planarisation et un bord du substrat souple soit de 10 cm ou moins à l'étape b).

14. Procédé de fabrication d'un appareil d'affichage souple selon la revendication 11, dans lequel la couche de protection forme une feuille plastique comprenant un matériau de barrière aux gaz et est attachée au substrat souple à l'étape d).

15. Procédé de fabrication d'un appareil d'affichage souple selon la revendication 11, dans lequel un matériau sélectionné dans le groupe consistant en un matériau de barrière aux gaz, un matériau organique, et un mélange de ceux-ci est appliqué au substrat souple pour former l'une quelconque d'une couche de protection du type monocouche et d'une couche de protection multicouche sur le substrat souple à l'étape d).

16. Procédé de fabrication d'un appareil d'affichage souple selon la revendication 11, dans lequel la couche de planarisation a une épaisseur de 10 µm ou moins à l'étape b).

17. Procédé de fabrication d'un appareil d'affichage souple selon la revendication 11, dans lequel le dispositif d'affichage est l'un quelconque d'un LCD cholestérique, d'un PDLC (cristal liquide dispersé dans un polymère), d'un dispositif électrophorétique et d'un OLED (dispositif électroluminescent organique) à l'étape c).

18. Procédé de fabrication d'un appareil d'affichage souple selon la revendication 11, dans lequel une couche de métal est formée sur une couche de résine en utilisant un processus de lamification pour réaliser le substrat souple à l'étape a).

19. Procédé de fabrication d'un appareil d'affichage souple selon la revendication 18, dans lequel la couche de résine est constituée d'au moins un élément sélectionné dans le groupe consistant en le PET (polyéthylène téréphtalate), le polyester, le PEN (polyéthylène naphtalate), le PEEK (polyétheréthercétone), le PC (polycarbonate), le PES (polyéthersulfone), le PI (polyimide), le PAR (polyarylate), la PCO (oléfine polycyclique) et le polynorbornène.

20. Procédé de fabrication d'un appareil d'affichage souple selon la revendication 18, dans lequel la couche de métal est constituée d'au moins un élément sélectionné dans le groupe consistant en l'aluminium et l'acier inoxydable.
